# EUROPÄISCHE PATENTSCHRIFT

(11) **EP 3 440 773 B1**
(45) Veröffentlichungstag und Bekanntmachung des Hinweises auf die Patenterteilung: **19.10.2022**
(21) Anmeldenummer: 16715454.1
(22) Anmeldetag: 07.04.2016
(51) Int. Cl.: H03K 17/968, H03K 17/97

(54) **BEDIENVORRICHTUNG, INSBESONDERE FÜR EIN HAUSHALTSGERÄT**
OPERATOR CONTROL APPARATUS, IN PARTICULAR FOR A DOMESTIC APPLIANCE
DISPOSITIF DE COMMANDE, EN PARTICULIER POUR APPAREIL DOMESTIQUE

(43) Veröffentlichungstag der Anmeldung: 13.02.2019
(73) Patentinhaber: Diehl AKO Stiftung & Co. KG, 88239 Wangen (DE)
(72) Erfinder: MAIGLER, Andreas, 88339 Bad Waldsee (DE); FUHGE, Bruno, 88147 Achberg (DE); LYSZUS, Joachim, 88255 Baindt (DE); STOHR, Ralph, 88299 Leutkirch (DE); FROMMELT, Thomas, 81243 München (DE); SCHWIND, Matthew, 88353 Kisslegg (DE)
(74) Vertreter: Diehl Patentabteilung
(86) Internationale Anmeldenummer: PCT/EP2016/000572
(87) Internationale Veröffentlichungsnummer: WO 2017/174097

(56) Entgegenhaltungen:
- EP-A1- 0 558 871
- DE-A1- 19 721 105
- DE-A1-102014 007 036

## Beschreibung

Die vorliegende Erfindung betrifft eine Bedienvorrichtung, insbesondere eine Bedienvorrichtung für ein elektronisches Haushaltsgerät.

Für Bedienvorrichtungen sind verschiedene Arten von Bedienelementen mit unterschiedlichen Funktionsweisen bekannt. Bei den als Drucktasten ausgebildeten Bedienelementen kann man zum Beispiel zwischen berührungs- und/oder annäherungsempfindlichen Drucktasten (sog. "Touch Control") und durch Krafteinwirkung betätigbaren Drucktasten differenzieren, die jeweils mit verschiedenen Aufbauten und Funktionsweisen realisierbar sind.

In diesem Zusammenhang sind bei den durch Krafteinwirkung betätigbaren Drucktasten neben solchen mit einem mechanischen Betätigungselement insbesondere auch kapazitive Drucktasten (vgl. z.B. DE 10 2011 121 897 A1), induktive Drucktasten (vgl. z.B. EP 2 529 484 B1) und piezoelektrische Drucktasten (vgl. z.B. EP 2 063 533 B1) bekannt. Diese speziellen Drucktasten erfordern im Allgemeinen eine hohe Fertigungs- und Montagegenauigkeit mit kleinen Toleranzbereichen.

Die EP 0 558 871 A1 offenbart eine durch Krafteinwirkung betätigbare Drucktaste, deren Betätigung mittels einer optischen Messvorrichtung qualitativ erfasst wird, wobei ein Pegel des Ausgangssignals der Messvorrichtung von einem Abstand einer mit Druck beaufschlagbaren Deckfolie zur Messvorrichtung abhängt. Darüber hinaus ist zum Beispiel aus der DE 10 2014 007 036 A1 der Anmelderin eine Bedienvorrichtung mit einer durch Krafteinwirkung betätigbaren Drucktaste bekannt, deren Betätigung mittels eines optischen Sensors qualitativ erfasst wird, wobei ein Erfassungsort der reflektierten Strahlung von einem Abstand einer mit Druck beaufschlagbaren Abdeckung zum Sensor abhängt. Diese bekannten Bedienvorrichtungen können trotz ihrer optischen Funktionsweise auch bei optisch undurchlässigen Abdeckplatten eingesetzt werden.

Der Erfindung liegt die Aufgabe zugrunde, eine verbesserte Bedienvorrichtung mit einer durch Krafteinwirkung betätigbaren Drucktaste zu schaffen, welche eine Erweiterung der Funktionalität der Drucktaste ermöglicht.

Diese Aufgabe wird gelöst durch eine Bedienvorrichtung mit den Merkmalen des Anspruchs 1. Besonders bevorzugte Ausgestaltungen und Weiterbildungen der Erfindung sind Gegenstand der abhängigen Ansprüche.

Die Bedienvorrichtung der Erfindung weist eine Abdeckplatte mit einer einem Benutzer zugewandten Benutzerseite und einer dem Benutzer abgewandten Rückseite, wobei die Abdeckplatte ein Bedienfeld definiert und in diesem Bedienfeld durch eine Krafteinwirkung von der Benutzerseite her zumindest teilweise elastisch verformbar und/oder bewegbar ist, und einen optischen Sensor mit einem Sender zum Emittieren von elektromagnetischer Strahlung und einem Empfänger zum ortsaufgelösten Erfassen von reflektierter elektromagnetischer Strahlung auf. Dabei ist das Bedienfeld durch unterschiedlich starke Krafteinwirkungen unterschiedlich stark verformbar und/oder bewegbar. Ferner ist eine Steuerelektronik zum Auswerten von vom Empfänger erzeugten Messsignalen vorgesehen, die derart ausgestaltet ist, dass sie in Abhängigkeit von einem Erfassungsort der reflektierten elektromagnetischen Strahlung eine Nicht-Betätigung des Bedienfeldes, eine Betätigung des Bedienfeldes mit einer ersten Krafteinwirkung und eine Betätigung des Bedienfeldes mit einer von der ersten Krafteinwirkung verschiedenen zweiten Krafteinwirkung differenziert.

Die erfindungsgemäße Bedienvorrichtung stellt eine Drucktaste mit optischer Detektion ihrer Betätigung dar, wobei diese optische Detektion unabhängig von der Lichtdurchlässigkeit der Abdeckplatte zuverlässig realisierbar ist. Bei der erfindungsgemäßen Bedienvorrichtung können insbesondere auch Abdeckplatten aus Metall eingesetzt werden.

Bei der erfindungsgemäßen Bedienvorrichtung ist das Bedienfeld durch unterschiedlich starke Krafteinwirkungen unterschiedlich stark verformbar bzw. bewegbar und ist die Steuerelektronik derart ausgestaltet, dass sie in Abhängigkeit von einem Erfassungsort der reflektierten elektromagnetischen Strahlung eine Nicht-Betätigung des Bedienfeldes, eine Betätigung des Bedienfeldes mit einer ersten Krafteinwirkung und eine Betätigung des Bedienfeldes mit einer von der ersten Krafteinwirkung verschiedenen zweiten Krafteinwirkung differenzieren kann. Bei einer ausreichend hohen Empfindlichkeit der Ortsauflösung bei der Erfassung der reflektierten Strahlung durch den Empfänger und auch der entsprechenden Auswertung durch die Steuerelektronik kann eine Betätigung des Bedienfeldes durch einen Benutzer nicht nur qualitativ, sondern auch quantitativ erfasst werden. Hierdurch ist es möglich, eine Drucktaste mit mehreren Bedienungsfunktionalitäten zu belegen. Im Ergebnis kann die Bedienvorrichtung dem Benutzer eine komfortablere Bedienung zum Beispiel eines elektronischen Haushaltsgeräts ermöglichen.

Die Abdeckplatte kann in diesem Zusammenhang aus einem beliebigen Material, mit beliebigen Dimensionierungen und mit beliebigem Design gefertigt sein. Bei der Abdeckplatte handelt es sich vorzugsweise um eine Bedienblende zum Beispiel eines elektronischen Haushaltsgerätes.

Das Bedienfeld ist vorzugsweise einstückig mit der Abdeckplatte ausgebildet, als separate Komponente in die Abdeckplatte eingesetzt oder als separate Komponente mit der Abdeckplatte verbunden. Das Bedienfeld definiert für den Benutzer die Drucktaste der Bedienvorrichtung, die er/sie durch eine Krafteinwirkung betätigen kann. Das Bedienfeld ist vorzugsweise für den Benutzer kenntlich gemacht, bevorzugt durch eine spezielle Formgebung seiner Benutzerseite (haptische Kennzeichnung), eine Kennzeichnung mit Farben und/oder Symbolen, eine Hinterleuchtung, eine erkennbare Abgrenzung zur übrigen Abdeckplatte und dergleichen.

Das Bedienfeld ist durch eine Krafteinwirkung von der Benutzerseite der Abdeckplatte her zumindest teilweise elastisch verformbar und/oder bewegbar. Die elastische Verformbarkeit wird vorzugsweise durch eine spezielle Materialauswahl und/oder eine spezielle Dimensionierung des Bedienfeldes erzielt. Die elastische Bewegbarkeit kann vorzugsweise durch eine gefederte Lagerung des Bedienfeldes in Durchbrechungen in der Abdeckplatte realisiert werden.

Bei der elektromagnetischen Strahlung, die von dem optischen Sensor emittiert und erfasst wird, handelt es sich vorzugsweise um optische Strahlung, bevorzugt im sichtbaren oder Infrarot-Wellenlängenbereich. Der Empfänger ist bezüglich der von ihm erfassbaren elektromagnetischen Strahlung auf die von dem Sender emittierte elektromagnetische Strahlung abgestimmt, bevorzugt stimmen die jeweiligen Wellenlängenbereiche im Wesentlichen überein oder haben einen signifikanten Überlappungsbereich.

Bei dem Sender des optischen Sensors handelt es sich vorzugsweise um eine Leuchtdiode (LEDs), Laserdiode, Glühlampe, Halogenlampe oder dergleichen. Der Sender kann aber auch durch Umgebungslicht realisiert werden, welches durch eine entsprechende Öffnung zum Beispiel im Gerätegehäuse oder in der Abdeckplatte auf die Rückseite des Bedienfeldes gelangen kann.

Der Empfänger des optischen Sensors ermöglicht eine ortsaufgelöste Erfassung der reflektierten Strahlung. Vorzugsweise ist der Empfänger durch genau ein Empfängerelement mit einer ortsauflösenden Funktionsweise oder durch mehrere nebeneinander angeordnete Empfängerelemente gebildet. Die Empfängerelemente sind dementsprechend bevorzugt ausgewählt aus CCD-Chips, aktiven Pixelsensoren, Photodioden, Phototransistoren, Umgebungslichtsensoren und dergleichen.

Gemäß der Erfindung ist die Steuerelektronik außerdem derart ausgestaltet, dass sie einer Betätigung des Bedienfeldes mit der ersten Krafteinwirkung eine erste Bedienungsfunktionalität zuordnet und einer Betätigung des Bedienfeldes mit der zweiten Krafteinwirkung eine von der ersten Bedienungsfunktionalität verschiedene zweite Bedienungsfunktionalität zuordnet. Bei den Bedienungsfunktionalitäten handelt es sich beispielsweise um die Einstellung verschiedener Parameter, die Auswahl verschiedener Funktionen, verschiedene Eingabemodi und dergleichen.

Vorzugsweise ist eine Trägerplatte vorgesehen, die auf einer Rückseite der Abdeckplatte zu dieser beabstandet angeordnet ist. Diese Trägerplatte ist bevorzugt im Wesentlichen parallel zur Abdeckplatte angeordnet und beispielsweise als Leiterplatte ausgebildet.

In einer Ausführungsform der Erfindung ist der optische Sensor auf der Trägerplatte angeordnet und ist die Rückseite der Abdeckplatte im Bereich des Bedienfeldes zumindest teilweise die elektromagnetische Strahlung reflektierend ausgestaltet. In einer anderen Ausführungsform der Erfindung ist der optische Sensor an der Rückseite der Abdeckplatte angeordnet und ist eine der Abdeckplatte zuwandte Seite der Trägerplatte im Bereich des Bedienfeldes zumindest teilweise die elektromagnetische Strahlung reflektierend ausgestaltet. Die Reflexionseigenschaft des Bedienfeldes bzw. der Trägerplatte wird vorzugsweise erreicht durch eine spezielle Materialauswahl, eine spezielle Oberflächenstruktur, eine spezielle Oberflächenbehandlung (bevorzugt Beschichtung, etc.) oder dergleichen.

In einer vorteilhaften Ausgestaltung der Erfindung ist auf der Rückseite der Abdeckplatte um das Bedienfeld herum wenigstens eine formstabile Stütze vorgesehen, die eine elastische Verformung oder Bewegung der Abdeckplatte außerhalb des Bedienfeldes durch eine Krafteinwirkung von der Benutzerseite der Abdeckplatte her verhindert. Mit Hilfe dieser Stütze kann das Bedienfeld von der übrigen Abdeckplatte separiert werden, so dass sich nur das Bedienfeld elastisch verformt oder bewegt, wodurch eine zuverlässige Auswertung der Drucktastenbetätigung durch die Steuerelektronik ermöglicht wird. Die formstabile Stütze kann vorzugsweise auch der Abschirmung des optischen Sensors gegenüber seiner Umgebung dienen. Die Stütze ist bevorzugt für die vom Sender emittierte elektromagnetische Strahlung im Wesentlichen undurchlässig ausgestaltet. Die Stütze kann so zum Beispiel ein Übersprechen mit optischen Sensoren benachbarter weiterer Tasten oder dergleichen verhindern. Vorzugsweise ist die Stütze integral mit der Abdeckplatte oder Trägerplatte ausgebildet.

In einer weiteren vorteilhaften Ausgestaltung der Erfindung definiert die Abdeckplatte mehrere Bedienfelder, in denen sie jeweils durch eine Krafteinwirkung von der Benutzerseite her zumindest teilweise elastisch verformbar und/oder bewegbar ist, ist für jedes der mehreren Bedienfelder ein optischer Sensor mit einem Sender und einem Empfänger vorgesehen ist, und ist die Steuerelektronik zum Auswerten der von den Empfängern der mehreren optischen Sensoren erzeugten Messsignale ausgestaltet. Mit anderen Worten weist die Bedienvorrichtung mehrere Drucktasten der erfindungsgemäßen Konstruktion auf.

Bei dieser Ausführungsform können die optischen Sensoren der mehreren Drucktasten von der Steuerelektronik vorzugsweise getaktet betrieben werden. Auf diese Weise können Betätigungen von verschiedenen Bedienfeldern sicher voneinander differenziert werden.

Die Bedienvorrichtung kann neben dem durch eine Krafteinwirkung betätigbaren und optisch auswertbaren Bedienfeld zum Beispiel weitere Bedienfelder mit anderen Funktionsweisen aufweisen. Dabei können insbesondere auch einzelne Tasten, andere Drucktasten und berührungs- und/oder annäherungsempfindliche Tasten zum Einsatz kommen.

Gegenstand der Erfindung ist außerdem ein elektronisches Haushaltsgerät mit wenigstens einer oben beschriebenen Bedienvorrichtung der Erfindung.

Bei dem elektronischen Haushaltsgerät handelt es sich vorzugsweise um ein Wäschebehandlungsgerät (Waschmaschine, Wäschetrockner, etc.), eine Spülmaschine, ein Kühl- und/oder Gefriergerät (Kühlschrank, Gefriertruhe, etc.), ein Kochfeld, einen Herd, einen Mikrowellenofen, einen Dunstabzug oder dergleichen.

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnung besser verständlich. Darin zeigen:

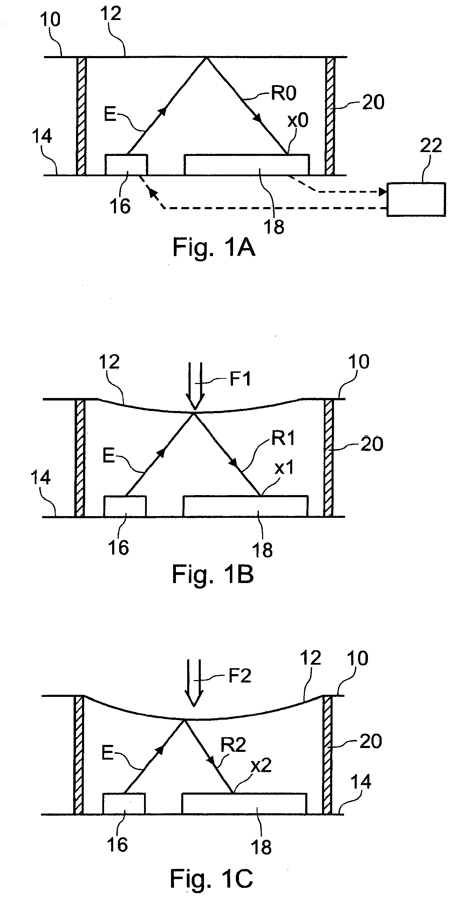

- Fig. 1A: eine schematische Darstellung einer Bedienvorrichtung der Erfindung im Zustand einer Nicht-Betätigung des Bedienfeldes;
- Fig. 1B: eine schematische Darstellung der Bedienvorrichtung von Fig. 1A im Zustand einer Betätigung des Bedienfeldes mit einer ersten Krafteinwirkung; und
- Fig. 1C: eine schematische Darstellung der Bedienvorrichtung von Fig. 1A im Zustand einer Betätigung des Bedienfeldes mit einer zweiten Krafteinwirkung.

Die Bedienvorrichtung weist eine Abdeckplatte 10 zum Beispiel in Form einer Bedienblende zum Beispiel eines elektronischen Haushaltsgerätes auf. Diese Abdeckplatte 10 hat eine einem Benutzer zugewandte Benutzerseite (oben in Fig. 1A-C), welche der Außenseite der Bedienblende bzw. des Gerätes entspricht, und eine einem Benutzer abgewandte Rückseite (unten in Fig. 1A-C), welche der Innenseite der Bedienblende bzw. des Gerätes entspricht. Die Abdeckplatte 10 ist beispielsweise aus Kunststoff oder Metall gefertigt.

Diese Abdeckplatte 10 weist ein Bedienfeld 12 auf, das für den Benutzer eine Drucktaste definiert, die der Benutzer betätigen kann. Das Bedienfeld 12 ist in die Abdeckplatte 10 integriert bzw. einteilig mit dieser ausgebildet oder als separate Komponenten in diese eingesetzt und wahlweise mit dieser verbunden. Wie ein Vergleich der Fig. 1A-C zeigt, ist das Bedienfeld 12 durch eine Krafteinwirkung in Form einer Druckkraft von der Benutzerseite her, zum Beispiel mit einem Finger des Benutzers, elastisch verformbar ausgestaltet. D.h. nach Beendigung der Krafteinwirkung kehrt das Bedienfeld 12 wieder in seinen Ausgangszustand von Fig. 1A zurück.

Das Bedienfeld 12 ist vorzugsweise für den Benutzer gekennzeichnet, damit dieser es leichter auffinden und seine Funktionalität identifizieren kann. Hierzu können das Bedienfeld 12 oder seine Außenseite selbst gekennzeichnet sein oder kann die Abdeckplatte 10 in der Nähe des Bedienfeldes 12 gekennzeichnet sein. Die Kennzeichnung erfolgt zum Beispiel optisch durch Farben und/oder Symbole, haptisch durch Oberflächenstrukturen, elektrisch durch eine Hinterleuchtung oder Signallampen, oder dergleichen.

Hinter der Abdeckplatte 10 ist im Wesentlichen parallel und mit Abstand zu dieser eine Trägerplatte 14 in Form einer Leiterplatte angeordnet. Auf dieser Trägerplatte 14 kann eine Steuerelektronik 22 vorgesehen sein, die mit einer Steuerung des Haushaltsgeräts verbunden ist. Die Steuerelektronik 22 kann wahlweise auch separat von der Trägerplatte 14 positioniert sein.

Das Bedienfeld 12 ist von wenigstens einer formstabilen Stütze 20 in Form eines Stützsteges auf der Rückseite der Abdeckplatte 10 umgeben. Diese Stütze 20 verhindert eine elastische Verformung der Abdeckplatte 10 im Bereich außerhalb des Bedienfeldes 12. Die Stütze 20 ist vorzugsweise lichtundurchlässig ausgestaltet, sodass sie gleichzeitig einen Sensorrahmen für den nachfolgend beschriebenen optischen Sensor bildet, der auch ein Übersprechen zwischen benachbarten Sensoren optischer Tasten der Bedienvorrichtung verhindern kann. Die Stütze 20 ist beispielsweise auf der Trägerplatte 14 montiert (z.B. mittels Spritzgießens) und/oder mit der Rückseite der Abdeckplatte 10 verklebt (alternativ verschraubt, verrastet oder dergleichen).

Die Bedienvorrichtung weist ferner einen optischen Sensor mit einem Sender 16 zum Beispiel in Form einer LED und einem Empfänger 18 zum Beispiel in Form eines CCD-Chips auf. Der Sender 16 emittiert elektromagnetische Strahlung, vorzugsweise Licht im sichtbaren oder Infrarot-Wellenlängenbereich, und der Empfänger 18 kann elektromagnetische Strahlung desselben Wellenlängenbereichs erfassen.

Der Empfänger 18 ist dabei so ausgestaltet, dass er Strahlung ortsaufgelöst erfassen kann. Dies bedeutet, dass ein einzelnes Empfängerelement über eine solche Fähigkeit verfügt (z.B. CCD-Chip, SensorArray, etc.) oder mehrere Empfängerelemente (z.B. Photodioden, Phototransistoren, etc.) nebeneinander angeordnet sind und gemeinsam ausgewertet werden.

Der Sender 16 und der Empfänger 18 des optischen Sensors sind mit der Steuerelektronik 22 verbunden. Die Steuerelektronik 22 weist zum Beispiel einen Mikrocontroller auf bzw. ist aus einem solchen gebildet. Die Steuerelektronik 22 steuert den Sender 16 an, d.h. schaltet diesen im einfachsten Fall nur an und aus. Außerdem wertet die Steuerelektronik 22 die vom Empfänger 18 erzeugten Messsignale aus, um eine Betätigung des Bedienfeldes 12 durch einen Benutzer detektieren zu können.

Wie in Fig. 1A-C veranschaulicht, funktionieren die optischen Sensoren dabei insbesondere wie folgt. Die vom Sender 16 emittierte Strahlung E trifft im Bereich des Bedienfeldes 12 auf die Rückseite der Abdeckplatte 10 und wird dort reflektiert. Die am Bedienfeld 12 reflektierte Strahlung R0, R1, R2 trifft dann auf den Empfänger 18 und wird von diesem erfasst, der entsprechende Messsignale erzeugt, die von der Steuerelektronik 22 ausgewertet werden.

Im Ausgangszustand von Fig. 1A, d.h. ohne Betätigung des Bedienfeldes 12 durch den Benutzer, befindet sich das Bedienfeld 12 in seinem unverformten Ausgangszustand und reflektiert die Strahlung R0 zum Empfänger 18. Der Empfänger 18 detektiert die reflektierte Strahlung R0 an einem entsprechenden Erfassungsort x0.

Bei einer ersten Krafteinwirkung F1, d.h. beim Betätigen des Bedienfeldes mit einer ersten Druckkraft, verformt sich die Abdeckplatte 10 im Bereich des Bedienfeldes 12, wie in Fig. 1B beispielhaft dargestellt. Hierdurch verschiebt sich der Reflexionsort der Strahlung E an der Rückseite des Bedienfeldes 12. Als Ergebnis verschiebt sich auch der Reflexionsort am Empfänger, sodass der Empfänger 18 die reflektierte Strahlung R1 an einem Reflexionsort x1 erfasst, der sich deutlich von dem Reflexionsort x0 unterscheidet.

Bei einer zweiten Krafteinwirkung F1, deren Stärke sich deutlich von der ersten Krafteinwirkung F1 unterscheidet, verformt sich die Abdeckplatte 10 im Bereich des Bedienfeldes 12 noch weiter, wie in Fig. 1C beispielhaft dargestellt. Hierdurch verschiebt sich auch der Reflexionsort der Strahlung E an der Rückseite des Bedienfeldes 12 weiter. Als Ergebnis verschiebt sich der Reflexionsort am Empfänger, sodass der Empfänger 18 die reflektierte Strahlung R2 an einem Reflexionsort x2 erfasst, der sich deutlich von dem Reflexionsort x0 und dem Reflexionsort x1 unterscheidet.

Selbst relativ geringe Unterschiede in der Verformung des Bedienfeldes 12 haben deutliche Veränderungen im Erfassungsort der reflektierten Strahlung am Empfänger 18 zur Folge. Der ortsauflösende Empfänger 18 liefert an die Steuerelektronik 22 Messsignale, die insbesondere auch Daten zum Erfassungsort x0, x1, x2 enthalten. Die Steuerelektronik 22 ist so ausgestaltet, dass sie die Messsignale des Empfängers 18 so auswerten kann, dass sie in Abhängigkeit von dem jeweiligen Erfassungsort x0, x1, x2 eine Nicht-Betätigung des Bedienfeldes 12 (Fig. 1A), eine Betätigung des Bedienfeldes 12 mit der ersten Krafteinwirkung F1 (Fig. 1B) und eine Betätigung des Bedienfeldes 12 mit der zweiten Krafteinwirkung F2 (Fig. 1C) differenzieren kann.

Im Gegensatz zu einer herkömmlichen Drucktaste mit optischem Erfassungsprinzip, wie sie zum Beispiel aus der DE 10 2014 007 036 A1 bekannt ist, erkennt die Steuerelektronik 22 also nicht nur eine Betätigung des Bedienfeldes 12, sondern erkennt diese Betätigung auch quantitativ.

So kann die Drucktaste zwei unterschiedliche Bedienungsfunktionalitäten bereitstellen, indem die Steuerelektronik 22 einer Betätigung des Bedienfeldes 12 mit der ersten Krafteinwirkung F1 eine erste Bedienungsfunktionalität zuordnet und einer Betätigung des Bedienfeldes 12 mit der zweiten Krafteinwirkung F2 eine von der ersten Bedienungsfunktionalität verschiedene erste Bedienungsfunktionalität zuordnet. Beispielsweise kann bei einer Betätigung des Bedienfeldes 12 mit der ersten Krafteinwirkung F1 ein Parameter (z.B. Kochzeit, Kochstufe, etc.) langsam verändert (z.B. vergrößert oder verkleinert) werden, während bei einer Betätigung des Bedienfeldes 12 mit der zweiten Krafteinwirkung F2 der Parameter schnell (z.B. in Fünfer- oder Zehnerschritten) verändert wird.

Vorzugswiese erhält der Benutzer ein optisches, haptisches und/oder akustisches Feedback über seine/ihre Betätigung des Bedienfeldes 12 und die erkannte Krafteinwirkung F1 oder F2.

Selbstverständlich ist die Erfindung nicht auf Bedienvorrichtungen mit zwei Betätigungsstufen beschränkt. Je nach Anwendung und Ausführungsform kann die Bedienvorrichtung auch zum Differenzieren von drei, vier oder mehr Betätigungsstufen ausgebildet sein.

In dem Ausführungsbeispiel von Fig. 1A-C weist die Bedienvorrichtung eine Drucktaste mit einem Bedienfeld und einem optischen Sensor auf. In anderen Ausführungsformen der Erfindung kann die Bedienvorrichtung auch mehrere Drucktasten enthalten, die jeweils ein Bedienfeld und einen optischen Sensor aufweisen. Im Fall von mehreren Drucktasten können diese unabhängig voneinander ausgestaltet sein und ausgewertet werden. In anderen Ausführungsformen der Erfindung können auch mehrere Drucktasten zu einem gemeinsamen Bedienelement kombiniert sein, um einen Schieberegler, Slider oder dergleichen zu bilden.

In dem Ausführungsbeispiel von Fig. 1A-C ist der optische Sensor auf der Trägerplatte 14 montiert und wird die vom Sender emittierte Strahlung E an der Rückseite des Bedienfeldes 12 reflektiert. In einer anderen Ausführungsform der Erfindung sind der Sender 16 und der Empfänger 18 des optischen Sensors an der Rückseite der Abdeckplatte 10 montiert. Dementsprechend ist die der Abdeckplatte 10 zugewandte Seite der Trägerplatte 14 die elektromagnetische Strahlung reflektierend ausgestaltet.

In Ausführungsvarianten kann die oben beschriebene Bedienvorrichtung auch derart modifiziert werden, dass die Steuerelektronik 22 die optischen Sensoren automatisch nachkalibrieren kann.

Wie oben erläutert, wird die elektromagnetische Strahlung E vom Sender 16 über die Reflexion an einer Oberfläche (Rückseite der Abdeckplatte 10 oder Seite der Trägerplatte 14) als reflektierte Strahlung zum Empfänger 18 geleitet. Über den Empfänger 18 wird das Grundsignal R0 ausgewertet und als Referenz-signal im unbetätigten Zustand ohne Krafteinwirkung auf das Bedienfeld 12 verwendet. Ändert sich dieses Referenzsignal durch äußere Einflüsse (z.B. Temperatur, Feuchtigkeit, etc.), sich verändernde Reflexionseigenschaften der jeweiligen Oberfläche (z.B. aufgrund Oxidation, Verschmutzung, Änderung des Abstandes der Sende/Empfangselemente zur Reflexionsoberfläche z.B. durch thermische Ausdehnung, Alterung der Verbindungselemente etc.), dann ändert sich das Referenzsignal. Dies kann dazu führen, dass das Referenzsignal nachgeführt werden muss. Eine solche Nachführung des Referenzsignals kann beispielsweise durch eine Änderung der vom Sender 18 emittierten elektromagnetischen Strahlung E über ein Stellglied (z.B. einen LED-Treiber) erfolgen. Gleichzeitig kann auch eine Alterung des Senders 16 und/oder des Empfängers 18 des optischen Sensors über eine Nachführung der Sendeleistung kompensiert werden, um das Referenzsignal in einem bestimmten Bereich zu halten.

Obwohl nicht dargestellt, kann in weiteren Ausführungsbeispielen der Erfindung die Ausgestaltung des Bedienabschnitts 12 in der Abdeckplatte 10 abgewandelt werden. Während das Bedienfeld 12 in den oben beschriebenen Ausführungsformen jeweils durch eine Krafteinwirkung F1, F2 durch einen Benutzer elastisch verformbar ausgestaltet ist, kann das Bedienfeld 12 alternativ durch eine Krafteinwirkung durch einen Benutzer bewegbar sein. Zu diesem Zweck ist das Bedienfeld 12 bevorzugt als eine von der Abdeckplatte 10 separate Komponente gefertigt und beweglich in einer Durchbrechung in der Abdeckplatte 10 gelagert. Bei einer Betätigung des Bedienfeldes 12 wird dieses -je nach Stärke der Krafteinwirkung F1, F2 unterschiedlich weit - in die Abdeckplatte 10 hinein gedrückt und nach innen verschoben; nach Beendigung der Krafteinwirkung kehrt das Bedienfeld 12 dann wieder in seine Ausgangsposition zurück. Dies geschieht zum Beispiel mit Hilfe eines elastischen Federelements, das das Bedienfeld 12 in seine Ausgangsposition vorspannt.

Obwohl nicht dargestellt, können die oben beschriebenen Ausführungsformen auch derart modifiziert werden, dass die Abdeckplatte 10 im Bereich und/oder in der Nähe des Bedienfeldes 12 zumindest teilweise lichtdurchlässig ausgestaltet ist und wenigstens eine Lichtquelle auf der Trägerplatte 14 montiert ist. Bei dieser Ausgestaltung kann das Bedienfeld 12 für den Benutzer optisch gekennzeichnet werden und/oder kann dem Benutzer ein Feedback über den Betriebszustand der Bedienvorrichtung bzw. des Geräts, in dem die Bedienvorrichtung verbaut ist, gegeben werden.

### BEZUGSZIFFERNLISTE

- 10: Abdeckplatte, z.B. Bedienblende
- 12: Bedienfeld
- 14: Trägerplatte, z.B. Leiterplatte
- 16: Sender
- 18: Empfänger
- 20: Stützen, z.B. Stützstege
- 22: Steuerelektronik
- E: emittierte Strahlung
- F1: erste Krafteinwirkung, z.B. Druckkraft
- F2: zweite Krafteinwirkung, z.B. Druckkraft
- R0: reflektierte Strahlung ohne Krafteinwirkung
- R1: reflektierte Strahlung bei Krafteinwirkung F1
- R2: reflektierte Strahlung bei Krafteinwirkung F2
- x0, x1, x2: Erfassungsorte am Empfänger

## Patentansprüche

1. Bedienvorrichtung, insbesondere für ein elektronisches Haushaltsgerät, aufweisend:
eine Abdeckplatte (10) mit einer einem Benutzer zugewandten Benutzerseite und einer dem Benutzer abgewandten Rückseite, wobei die Abdeckplatte (10) ein Bedienfeld (12) definiert und in diesem Bedienfeld (12) durch eine Krafteinwirkung (F1, F2) von der Benutzerseite her zumindest teilweise elastisch verformbar und/oder bewegbar ist;
einen optischen Sensor mit einem Sender (16) zum Emittieren von elektromagnetischer Strahlung (E) und einem Empfänger (18) zum ortsaufgelösten Erfassen von reflektierter elektromagnetischer Strahlung (R0, R1, R2); und
eine Steuerelektronik (22) zum Auswerten von vom Empfänger (18) erzeugten Messsignalen, wobei
das Bedienfeld (12) durch unterschiedlich starke Krafteinwirkungen (F1, F2) unterschiedlich stark verformbar und/oder bewegbar ist; **dadurch gekennzeichnet, dass**
die Steuerelektronik (22) derart ausgestaltet ist, dass sie in Abhängigkeit von einem Erfassungsort (x0, x1, x2) der reflektierten elektromagnetischen Strahlung (R0, R1, R2) eine Nicht-Betätigung des Bedienfeldes (12), eine Betätigung des Bedienfeldes (12) mit einer ersten Krafteinwirkung (F1) und eine Betätigung des Bedienfeldes (12) mit einer von der ersten Krafteinwirkung verschiedenen zweiten Krafteinwirkung (F2) differenziert und einer Betätigung des Bedienfeldes (12) mit der ersten Krafteinwirkung (F1) eine erste Bedienungsfunktionalität zuordnet und einer Betätigung des Bedienfeldes (12) mit der zweiten Krafteinwirkung (F2) eine von der ersten Bedienungsfunktionalität verschiedene zweite Bedienungsfunktionalität zuordnet.

2. Bedienvorrichtung nach Anspruch 1, bei welcher
die verschiedenen Bedienungsfunktionalitäten ausgewählt sind aus einer Einstellung verschiedener Parameter, einer Auswahl verschiedener Funktionen und verschiedenen Eingabemodi.

3. Bedienvorrichtung nach Anspruch 1 oder 2, bei welcher
eine Trägerplatte (14) vorgesehen ist, die auf einer Rückseite der Abdeckplatte (10) zu dieser beabstandet angeordnet ist;
der optische Sensor auf der Trägerplatte (14) angeordnet ist; und
die Rückseite der Abdeckplatte (10) im Bereich des Bedienfeldes (12) zumindest teilweise die elektromagnetische Strahlung reflektierend ausgestaltet ist.

4. Bedienvorrichtung nach Anspruch 1 oder 2, bei welcher
eine Trägerplatte (14) vorgesehen ist, die auf einer der Rückseite der Abdeckplatte (10) zu dieser beabstandet angeordnet ist;
der optische Sensor an der Rückseite der Abdeckplatte (10) angeordnet ist; und
eine der Abdeckplatte (10) zuwandte Seite der Trägerplatte (14) im Bereich des Bedienfeldes (12) zumindest teilweise die elektromagnetische Strahlung reflektierend ausgestaltet ist.

5. Bedienvorrichtung nach einem der vorhergehenden Ansprüche, bei welcher
auf der Rückseite der Abdeckplatte (10) um das Bedienfeld (12) herum wenigstens eine formstabile Stütze (20) vorgesehen ist, die eine elastische Verformung oder Bewegung der Abdeckplatte (10) außerhalb des Bedienfeldes (12) durch eine Krafteinwirkung (F1, F2) von der Benutzerseite der Abdeckplatte (10) her verhindert.

6. Bedienvorrichtung nach Anspruch 5, bei welcher
die wenigstens eine Stütze (20) für die von dem Sender (16) emittierte Strahlung (E) im Wesentlichen undurchlässig ist.

7. Bedienvorrichtung nach Anspruch 5 oder 6, bei welcher
die wenigstens eine Stütze (20) integral mit der Abdeckplatte (10) oder der Trägerplatte (14) ausgebildet ist.

8. Bedienvorrichtung nach einem der vorhergehenden Ansprüche, bei welcher
die Abdeckplatte (10) mehrere Bedienfelder (12) definiert, in denen sie jeweils durch eine Krafteinwirkung (F1, F2) von der Benutzerseite her zumindest teilweise elastisch verformbar und/oder bewegbar ist;
für jedes der mehreren Bedienfelder (12) ein optischer Sensor mit einem Sender (16) und einem Empfänger (18) vorgesehen ist; und
die Steuerelektronik (22) zum Auswerten der von den Empfängern (18) der mehreren optischen Sensoren erzeugten Messsignale ausgestaltet ist.

9. Elektronisches Haushaltsgerät mit wenigstens einer Bedienvorrichtung nach einem der vorhergehenden Ansprüche.

## Claims

1. Operator control apparatus, in particular for an electronic domestic appliance, having:
a covering plate (10) with a user side which faces a user and a rear side which faces away from the user, wherein the covering plate (10) defines an operator control panel (12) and can be at least partially elastically deformed and/or moved in this operator control panel (12) by an action of force (F1, F2) from the user side;
an optical sensor with a transmitter (16) for emitting electromagnetic radiation (E) and a receiver (18) for detecting reflected electromagnetic radiation (R0, R1, R2) in a spatially resolved manner; and
a control electronics system (22) for evaluating measurement signals which are generated by the receiver (18),
wherein
the operator control panel (12) can be deformed and/or moved to different extents by actions of force (F1, F2) of different intensity;
**characterized in that**
the control electronics system (22) is designed in such a way that it differentiates between non-operation of the operator control panel (12), operation of the operator control panel (12) with a first action of force (F1) and operation of the operator control panel (12) with a second action of force (F2), which is different from the first action of force, depending on a detection location (x0, x1, x2) of the reflected electromagnetic radiation (R0, R1, R2), and assigns a first operator control functionality to operation of the operator control panel (12) with the first action of force (F1) and assigns a second operator control functionality, which is different from the first operator control functionality, to operation of the operator control panel (12) with the second action of force (F2).

2. Operator control apparatus according to Claim 1, in which
the various operator control functionalities are selected from an adjustment of various parameters, a selection of various functions and various input modes.

3. Operator control apparatus according to Claim 1 or 2, in which
a carrier plate (14) is provided, which is arranged on a rear side of the covering plate (10) at a distance from the latter;
the optical sensor is arranged on the carrier plate (14); and
the rear side of the covering plate (10) is designed to at least partially reflect the electromagnetic radiation in the region of the operator control panel (12).

4. Operator control apparatus according to Claim 1 or 2, in which
a carrier plate (14) is provided, which is arranged on a rear side of the covering plate (10) at a distance from the latter;
the optical sensor is arranged on the rear side of the covering plate (10); and
a side of the carrier plate (14) which faces the covering plate (10) is designed to at least partially reflect the electromagnetic radiation in the region of the operator control panel (12).

5. Operator control apparatus according to one of the preceding claims, in which at least one dimensionally stable support (20) is provided on the rear side of the covering plate (10) around the operator control panel (12), which support prevents elastic deformation or movement of the covering plate (10) outside the operator control panel (12) by an action of force (F1, F2) from the user side of the covering plate (10).

6. Operator control apparatus according to Claim 5, in which
the at least one support (20) is substantially opaque to the radiation (E) emitted by the transmitter (16).

7. Operator control apparatus according to Claim 5 or 6, in which
the at least one support (20) is integrally formed with the covering plate (10) or the carrier plate (14).

8. Operator control apparatus according to one of the preceding claims, in which
the covering plate (10) defines a plurality of operator control panels (12), in which the covering plate can in each case be at least partially elastically deformed and/or moved by an action of force (F1, F2) from the user side;
an optical sensor with a transmitter (16) and a receiver (18) is provided for each of the plurality of operator control panels (12); and
the control electronics system (22) is designed to evaluate the measurement signals which are generated by the receivers (18) of the plurality of optical sensors.

9. Electronic domestic appliance having at least one operator control apparatus according to one of the preceding claims.

## Revendications

1. Dispositif d'action, notamment d'un appareil électroménager, comportant :
une plaque de recouvrement (10) pourvue d'un côté utilisateur dirigé vers un utilisateur et d'un côté arrière dirigé à l'opposé de l'utilisateur, la plaque de recouvrement (10) définissant une zone d'action (12) et étant mobile et/ou au moins partiellement déformable élastiquement dans cette zone d'action (12) par une force (F1, F2) exercée depuis le côté utilisateur ;
un capteur optique comprenant un émetteur (16) destiné à émettre un rayonnement électromagnétique (E) et un récepteur (18) destiné à effectuer une détection à résolution spatiale du rayonnement électromagnétique réfléchi (R0, R1, R2) ; et
une électronique de commande (22) destinée à évaluer des signaux de mesure générés par le récepteur (18), la zone d'action (12) étant mobile et/ou déformable à des degrés différents à l'aide d'une force (F1, F2) de différentes intensités ;
**caractérisé en ce que**
l'électronique de commande (22) est conçue de manière à différencier, en fonction d'un emplacement de détection (x0, x1, x2) du rayonnement électromagnétique réfléchi (R0, R1, R2), un non-actionnement de la zone d'action (12), un actionnement de la zone d'action (12) avec une première force (F1) et un actionnement de la zone d'action (12) avec une deuxième force (F2) différente de la première force et associer une première fonctionnalité d'action à un actionnement de la zone d'action (12) avec la première force (F1) et associer une deuxième fonctionnalité d'action, différente de la première fonctionnalité d'action, à un actionnement de la zone d'action (12) avec la deuxième force (F2).

2. Dispositif d'action selon la revendication 1, dans lequel les différentes fonctionnalités d'action sont sélectionnées parmi un réglage de différents paramètres, une sélection de différentes fonctions et différents modes de saisie.

3. Dispositif d'action selon la revendication 1 ou 2, dans lequel
une plaque de support (14) est prévue qui est disposée sur un côté arrière de la plaque de recouvrement (10) à distance de celle-ci ;
le capteur optique est disposé sur la plaque de support (14) ; et
le côté arrière de la plaque de recouvrement (10) est conçu pour réfléchir au moins partiellement le rayonnement électromagnétique au niveau de la zone d'action (12).

4. Dispositif d'action selon la revendication 1 ou 2, dans lequel
une plaque de support (14) est prévue qui est disposée sur un côté arrière de la plaque de recouvrement (10) à distance de celle-ci ;
le capteur optique est disposé du côté arrière de la plaque de recouvrement (10) ; et
un côté de la plaque de support (14) qui est dirigé vers la plaque de recouvrement (10) est conçu pour réfléchir au moins partiellement le rayonnement électromagnétique au niveau de la zone d'action (12).

5. Dispositif d'action selon l'une des revendications précédentes, dans lequel
au moins un support dimensionnellement stable (20) est prévu du côté arrière de la plaque de recouvrement (10) autour de la zone d'action (12), lequel support empêche la déformation élastique ou le déplacement de la plaque de recouvrement (10) à l'extérieur de la zone d'action (12) par une force (F1, F2) exercée du côté utilisateur de la plaque de recouvrement (10).

6. Dispositif d'action selon la revendication 5, dans lequel
l'au moins un support (20) est sensiblement opaque au rayonnement (E) émis par l'émetteur (16).

7. Dispositif d'action selon la revendication 5 ou 6, dans lequel
l'au moins un support (20) est formé d'une seule pièce avec la plaque de recouvrement (10) ou la plaque de support (14).

8. Dispositif d'action selon l'une des revendications précédentes, dans lequel
la plaque de recouvrement (10) définit une pluralité de zones d'action (12) dans lesquelles elle est mobile et/ou au moins partiellement déformable élastiquement à chaque fois par une force (F1, F2) exercée du côté utilisateur ;
un capteur optique comprenant un émetteur (16) et un récepteur (18) est prévu pour chacune de la pluralité de zones d'action (12) ; et
l'électronique de commande (22) est conçue pour évaluer les signaux de mesure générés par les récepteurs (18) de la pluralité de capteurs optiques.

9. Appareil électroménager comprenant au moins un dispositif d'action selon l'une des revendications précédentes.
